# FASCICULE DE BREVET EUROPEEN

(11) **EP 4 422 871 B1**
(45) Date de publication et mention de la délivrance du brevet: **10.09.2025**
(21) Numéro de dépôt: 22764413.5
(22) Date de dépôt: 10.08.2022
(51) Int. Cl.: B41J 2/32, B41J 29/02

(54) **SYSTÈME D'IMPRESSION THERMIQUE**
THERMODRUCKSYSTEM
THERMAL PRINTING SYSTEM

(30) Priorité: 27.10.2021 FR 2111416
(43) Date de publication de la demande: 04.09.2024
(73) Titulaire: APS France, 49070 Beaucouzé (FR)
(72) Inventeur: MONTAGUTELLI, Denis, 49100 Angers (FR)
(74) Mandataire: Lequien, Philippe
(86) Numéro de dépôt international: PCT/EP2022/072491
(87) Numéro de publication internationale: WO 2023/072452

(56) Documents cités:
- US-A1- 2019 240 991

## Description

Le domaine de l'invention est celui de la conception et de la fabrication des systèmes d'impression.

Plus précisément, l'invention concerne un système d'impression thermique.

Les systèmes d'impression thermique sont notamment connus pour l'impression de tickets à la demande.

A titre d'exemple, on retrouve les systèmes d'impression thermique dans des équipements autonomes tels que des distributeurs de tickets de parking, des distributeurs de billets de train ou d'avion ou encore des systèmes d'impression de tickets de reçus ou de gestion de files d'attente.

Ces systèmes d'impression thermique sont donc intégrés dans des équipements et doivent être simples de maintenance, être compacts et susceptibles d'être fabriqués à faible coût.

Classiquement, les systèmes d'impression thermique sont constitués de deux parties, à savoir un châssis fixe et un châssis mobile surplombant le châssis fixe, le châssis mobile étant monté à rotation par rapport au châssis fixe.

Le châssis mobile peut ainsi adopter une position refermée dans laquelle il autorise l'impression d'une bande de papier, et une position ouverte dans laquelle il autorise la maintenance du système d'impression thermique.

Dans certains systèmes d'impression thermique, dits systèmes d'impression par le dessus, la face imprimée de la bande de papier est directement visible de l'utilisateur qui récupère l'impression. Ces systèmes d'impression par le dessus sont particulièrement utilisés pour l'impression de places ce cinéma, de tickets de parking ou de billets de transport.

Dans ces systèmes d'impression par le dessus, le châssis fixe supporte un rouleau d'impression mobile en rotation autour d'un axe de rotation. Le rouleau permet d'entraîner la bande de papier à imprimer via un moteur d'entraînement couplé au rouleau d'impression.

Le châssis mobile comprend, quant à lui, une tête d'impression intégrant un support en céramique qui porte une ligne de points chauffants permettant d'imprimer sur la bande de papier des caractères ou des images.

Le châssis mobile comprend également un mécanisme de ressort destiné à maintenir en appui la tête d'impression, et donc la ligne de points chauffants, contre le rouleau d'entraînement.

Classiquement, les bandes de papier à imprimer alimentant le système d'impression thermique sont conditionnées sous forme de rouleaux ou de bandes de longueur prédéterminée repliées en zig-zag.

Par ailleurs, ces systèmes d'impression thermique comprennent souvent des moyens de découpes positionnés en aval du châssis mobile et du châssis fixe selon le sens de défilement de la bande de papier pour découper la bande de papier après impression.

Ainsi, quand l'impression de la bande de papier est terminée, les moyens de découpe coupent le papier formant ainsi un ticket qui est délivré à un utilisateur final.

Certains systèmes d'impression thermique comprennent également une carte électronique pour piloter les fonctions d'impression et de découpes de la bande de papier.

Pour réaliser des opérations de maintenance, en particulier celles consistant à éliminer un bourrage papier, il est nécessaire de pouvoir séparer le châssis mobile du châssis fixe afin de libérer un espace situé entre la tête d'impression et le rouleau d'entraînement, ce qui permet de nettoyer une zone de passage de la bande de papier.

En d'autres termes, pour réaliser une maintenance du système d'impression thermique, il est nécessaire de positionner le châssis mobile dans sa position ouverte.

Cette séparation doit cependant prendre en compte une interface de connexion électrique entre le châssis mobile et le châssis fixe. Une telle interface de connexion permet en effet le transit continu d'informations et/ou de courants électriques entre le châssis fixe et le châssis mobile pour le pilotage de la tête d'impression par la carte électronique notamment.

Toutefois, cette interface de connexion électrique, qui permet le passage d'un nombre important de signaux électriques, doit bien entendu être repositionnée après chaque déplacement du châssis mobile par rapport au châssis fixe. En d'autres termes, l'interface de connexion électrique doit pouvoir reprendre une position identique permettant le transit des courants électriques et des informations à chaque repositionnement de la tête d'impression en appui sur le rouleau d'entraînement, cela malgré un nombre important de manipulations.

En effet, un mauvais repositionnement de l'interface de connexion électrique engendre un risque de dysfonctionnement du système d'impression thermique. Classiquement, cette interface de connexion électrique entre le châssis mobile et le châssis fixe est réalisée au moyen d'une pluralité de câbles électriques qu'il est nécessaire prendre en compte lors du déplacement et du repositionnement du châssis mobile par rapport au châssis fixe pour éviter leur rupture et/ou leur déconnexion de la tête d'impression.

Deux types de systèmes d'impression thermique coexistent actuellement sur le marché.

Un premier type consiste à monter le châssis mobile à rotation sur le châssis fixe par une charnière s'étendant selon un axe transversal à l'axe de rotation du rouleau d'impression, c'est-à-dire selon le sens de défilement de la bande de papier dans le système d'impression thermique.

Cette configuration présente comme principal avantage de pouvoir utiliser une nappe souple de connexion électrique entre le châssis mobile et le châssis fixe ce qui permet de rendre le système d'impression thermique plus compact et faible de coût. La nappe souple est alors positionnée en côté du système d'impression thermique.

Toutefois, ce système d'impression thermique présente un inconvénient majeur en ce qu'il nécessite un espace environnant le châssis mobile important pour la manipulation en pivotement du châssis mobile.

En effet, ce type de système présentant une largeur supérieure à sa profondeur, la rotation du châssis mobile engendre un balayement circulaire libre assez grand pour que le châssis mobile ne rencontre pas d'obstacle lors de sa rotation, les obstacles empêchant la séparation correcte du châssis mobile par rapport au châssis fixe.

Il est précisé que les dimensions de largeur et de profondeur sont définies par rapport à l'axe de rotation du rouleau d'entraînement. Aussi, la largeur se mesure parallèlement à l'axe de rotation du rouleau d'entraînement et la profondeur se mesure transversalement à l'axe de rotation du rouleau d'entraînement, c'est à dire selon le sens de défilement de la bande de papier dans le système d'impression thermique.

Il en résulte donc que, pour permettre une utilisation optimale du système d'impression selon cette première forme de réalisation, l'équipement dans lequel est monté le système d'impression doit présenter un espace non utilisé important permettant la manipulation et la rotation du châssis mobile par rapport au châssis fixe.

Or, dans les équipements intégrant ce type de système d'impression thermique, l'objectif de compacité est un critère important.

Selon un deuxième type connu, le châssis mobile est monté à rotation sur le châssis fixe selon un axe sensiblement parallèle à l'axe de rotation du rouleau d'impression.

Etant donné que le système d'impression thermique présente une largeur supérieure à sa profondeur, le volume disponible nécessaire au pivotement du châssis mobile par rapport au châssis fixe s'en trouve réduit par rapport au système à rotation transversal à l'axe de rotation du rouleau d'impression.

Cependant, le défilement de la bande de papier à imprimer se faisant dans le sens de la profondeur, il n'est pas possible de positionner les moyens de connexion électrique entre le châssis mobile et le châssis fixe au niveau de la charnière. Dans une telle position, les moyens de connexion électrique empêcheraient le passage de la bande de papier à imprimer.

Les moyens de connexion électrique, en l'espèce une pluralité de câbles, sont positionnés en côté du système d'impression thermique, ce qui en l'augmente sa largeur.

De plus, le pivotement du châssis mobile par rapport au châssis fixe nécessite une longueur de câble suffisamment importante pour permettre le pivotement du châssis mobile sans risquer d'arracher les moyens de connexion électrique.

En d'autres termes, les câbles formant les moyens de connexion électrique doivent présenter une longueur suffisante pour permettre le débattement du châssis mobile par rapport au châssis fixe ce qui peut former une gêne lors du rabattement du châssis mobile sur le châssis fixe.

Du domaine de l'invention, il est également connu le document de brevet publié sous le numéro US 2019/0240991 A1 qui décrit un système d'impression.

L'invention a notamment pour objectif de pallier les inconvénients de l'art antérieur.

Plus précisément, l'invention a pour objectif de proposer un système d'impression thermique permettant une maintenance aisée tout en limitant l'encombrement du système d'impression thermique.

L'invention a également pour objectif de fournir un tel système d'impression thermique dont le coût de fabrication est peu élevé.

L'invention a en outre pour objectif de fournir un tel système d'impression thermique qui soit sûr de fonctionnement.

Ces objectifs, ainsi que d'autres qui apparaîtront par la suite, sont atteints grâce à l'invention qui a pour objet un système d'impression thermique, du type comprenant :
- un châssis fixe et intégrant un rouleau d'entraînement mobile à rotation autour d'un axe d'entraînement et destiné à entraîner un défilement d'une bande de papier ;
- un châssis mobile surmontant le châssis fixe et portant une tête d'impression en regard du rouleau d'entraînement, le châssis mobile étant monté pivotant par rapport au châssis fixe autour d'un axe de rotation parallèle à l'axe d'entraînement entre une position refermée sur la surface de défilement et une position ouverte dans laquelle il est écarté de la surface de défilement,
- des moyens de connexion électrique de la tête d'impression à des moyens de pilotage,

caractérisé en ce que les moyens de connexion électrique prennent la forme d'une nappe souple de connexion électrique,
et en ce que la nappe souple présente, en côté du châssis fixe, dans la position refermée du châssis mobile, deux portions essentiellement planes s'étendant dans des plans parallèles entre eux, dont une première portion de connexion à des moyens de pilotage, solidaire du châssis fixe et une deuxième portion de connexion à la tête d'impression, solidaire du châssis mobile, la première portion et la deuxième portion étant reliées par un pli à 180° mobile dans un plan orthogonal à l'axe de rotation entre la position ouverte et la position refermée du châssis mobile ou inversement.

Un tel système d'impression thermique permet de combiner les avantages des systèmes d'impression thermique dont le pivotement du châssis mobile se fait selon un axe de rotation parallèle à l'axe d'entraînement avec les avantages des systèmes d'impression thermique dont le pivotement du châssis mobile se fait selon un axe de rotation transversal à l'axe d'entraînement, sans en prendre les inconvénients.

Plus particulièrement, le pivotement du châssis mobile selon un axe de rotation parallèle à l'axe d'entraînement permet de limiter le volume nécessaire à laisser libre autour du système d'impression thermique pour autoriser son ouverture ou sa fermeture, c'est-à-dire le passage du châssis mobile de sa position refermée à sa position ouverte, ou inversement.

Par ailleurs, l'utilisation d'une nappe souple de connexion électrique permet de maintenir la connexion électrique entre le châssis fixe et le châssis mobile sans risque de pincer et sectionner les câbles de connexion.

Cet avantage est renforcé par le fait que la nappe présente, en côté du châssis fixe selon l'axe de rotation, deux portions essentiellement planes reliées l'une à l'autre par un pli à 180° mobile dans un plan orthogonal à l'axe de rotation.

Ainsi, chaque portion se déplace relativement par rapport à l'autre lors du passage du châssis mobile de sa position refermée à sa position ouverte, et inversement, le pli à 180°pouvant se dérouler pour limiter la torsion de la nappe et donc son déchirement.

En outre, le pli à 180° permet de contrôler le bon déroulement et le bon enroulement de la nappe souple lors du changement de position du châssis mobile par rapport au châssis fixe.

Selon un aspect avantageux, la nappe souple comprend, lorsque positionnée à plat entre une troisième portion et une quatrième portion, une forme en U ayant une base, une première aile destinée à former la première portion, et une deuxième aile destinée à former la deuxième portion, la base présentant :
- une première ligne de pli de la nappe souple à 180° à la jonction entre la première aile et la deuxième aile ;
- une deuxième ligne de pli de la nappe souple à 180° à la jonction entre la première aile et la troisième portion, et
- une troisième ligne de pli de la nappe souple à 90° située entre la deuxième aile et la quatrième portion.

La nappe souple peut ainsi être fabriquée à plat avant d'être mise en forme selon les différentes lignes de pli.

Cela facilite alors la fabrication du système d'impression thermique ainsi que son assemblage.

D'autre part, le conditionnement à plat de la nappe souple permet l'intégration de composants électroniques avant de mettre en forme la nappe souple puis de l'intégrer au système d'impression thermique. Ce qui évite le recours à une multitude de câbles entre les composants portés chacun par un circuit électronique et une carte de contrôle commune.

Selon un autre aspect avantageux, le système d'impression thermique comprend également un dispositif de détection de la position du châssis mobile par rapport au châssis fixe, ce dispositif de détection étant relié à la carte électronique de pilotage du système d'impression thermique pour assurer une mise en sécurité du système d'impression thermique lorsque le châssis mobile est dans sa position ouverte.

Ainsi, lorsque le châssis mobile est dans sa position ouverte, la mise en chauffe (nécessaire à l'impression) de la tête d'impression peut être stoppée.

Selon un autre aspect avantageux, le dispositif de détection comprend :
- un capteur à effet hall solidaire de l'un du châssis fixe et du châssis mobile, et
- un aimant permanent solidaire de l'autre du châssis mobile et du châssis fixe,
le capteur et l'aimant étant en regard l'un de l'autre dans la position refermée du châssis mobile.

L'utilisation d'un capteur à effet hall permet une détection fine et précise de la position du châssis mobile par rapport au châssis fixe.

Dès lors, si la position entre le châssis mobile et le châssis fixe n'est plus conforme aux conditions d'impression, alors le dispositif de détection détectera cette non-conformité.

Selon un autre aspect avantageux, le système d'impression thermique comprend un mécanisme de verrouillage en position refermée du châssis mobile.

Le mécanisme de verrouillage permet d'éviter une ouverture involontaire du système d'impression.

En d'autres termes, le mécanisme de verrouillage permet d'assurer un maintien en condition de fonctionnement du système d'impression thermique.

Selon un autre aspect avantageux, le mécanisme de verrouillage comprend :
- un organe de manipulation solidaire du châssis mobile ;
- au moins un crochet solidaire de l'organe de manipulation, et
- au moins un organe de retenue du crochet solidaire du châssis fixe.

Une telle conception du mécanisme de verrouillage est simple et permet une intégration aisée dans le système d'impression thermique.

En outre, une telle conception rend le mécanisme simple de maintenance.

Selon un autre aspect avantageux, la deuxième portion de la nappe souple est fixée au châssis mobile par l'intermédiaire d'un ruban adhésif de type double face.

L'utilisation d'un tel ruban adhésif permet de faciliter l'assemblage du système d'impression.

En effet, grâce au ruban adhésif double face, il est possible de solidariser le ruban uniquement à la nappe souple ou au châssis mobile et de réaliser un pré-positionnement précis de la nappe souple avant sa solidarisation finale au châssis mobile ou à la nappe souple.

Les risques de mauvais positionnement de la nappe souple sur le châssis mobile sont ainsi limités, un mauvais positionnement pouvant engendrer un pincement voire un sectionnement de la nappe souple entre le châssis mobile et le châssis fixe.

Selon un autre aspect avantageux, le système d'impression thermique comprend un dispositif de découpe d'une bande de papier imprimée, le dispositif de découpe comprenant un premier organe de coupe solidaire du châssis fixe, et un deuxième organe de coupe solidaire du châssis mobile, en regard du premier organe de coupe.

Le dispositif de découpe permet ainsi de débiter la bande de papier après impression pour former des tickets à la taille adéquate.

Ce dispositif de découpe facilite ainsi le retrait du ticket par un utilisateur qui n'a alors pas à couper la bande de papier manuellement au risque de déchirer le ticket imprimé.

Selon un autre aspect avantageux, la nappe souple comprend une cinquième portion prolongeant la troisième portion et formant un pli externe à 90° avec la troisième portion.

La cinquième portion permet de maintenir une connexion électrique constante avec une carte électronique sans risques d'arrachement puisqu'elle est éloignée du pli à 180° qui permet la déformation de la nappe souple lors de la rotation du châssis mobile.

Selon un autre aspect avantageux, le système d'impression thermique comprend une carte électronique de pilotage du système d'impression thermique montée fixement par rapport au châssis fixe.

Cette carte électronique permet de piloter la tête d'impression.

Selon un autre aspect avantageux :
- la deuxième ligne de pli est destinée à former un axe de rayon de courbure d'un pli interne entre la première portion et la troisième portion,
- la première ligne de pli est destinée à former un axe de rayon de courbure du pli à 180°,
et en ce que, dans la position refermée du châssis mobile, la première ligne, la deuxième ligne de pli et l'axe de rotation sont perpendiculaires deux à deux dans un espace tridimensionnel.

La perpendicularité deux à deux de la première ligne, de la deuxième ligne de pli et de l'axe de rotation permet d'assurer une bonne mobilité du châssis mobile par rapport au châssis fixe au moins dans une rotation comprise entre 0° et 90°, ces valeurs d'angle correspondant respectivement à la position refermée et à la position ouverte du châssis mobile.

D'autres caractéristiques et avantages de l'invention apparaîtront plus clairement à la lecture de la description suivante d'un mode de réalisation préférentiel de l'invention, donné à titre d'exemple illustratif et non limitatif, et des dessins annexés parmi lesquels :
[Fig.1] la [Fig.1] est une vue en perspective de dessus d'un système d'impression thermique selon l'invention ;
[Fig.2] la [Fig.2] est une vue de côté d'une partie du système d'impression thermique selon l'invention ;
[Fig.3] la [Fig.3] est une vue en perspective de dessus d'un châssis fixe du système d'impression thermique selon l'invention ;
[Fig.4] la [Fig.4] est une vue en perspective de dessus d'un châssis mobile du système d'impression thermique selon l'invention ;
[Fig.5] la [Fig.5] est une vue en perspective de dessous d'un châssis mobile du système d'impression thermique selon l'invention ;
[Fig.6] la [Fig.6] est une vue en perspective de dessus d'une partie du système d'impression thermique selon l'invention ;
[Fig.7] la [Fig.7] est une vue en perspective de dessus d'une carte électronique du système d'impression thermique selon l'invention ;
[Fig.8] la [Fig.8] est une vue arrière en perspective de dessus d'une nappe souple permettant une connexion électrique entre une tête d'impression et la carte électronique du système d'impression thermique selon l'invention ;
[Fig.9] la [Fig.9] est une sur vue avant en perspective de dessus de la nappe souple du système d'impression thermique selon l'invention ;
[Fig.10] la [Fig.10] est une représentation schématique en développé d'une partie de la nappe souple de la [Fig.8],
[Fig.11] la [Fig.11] est un détail simplifié de la [Fig.8], illustrant le positionnement de plis de la nappe souple par rapport à un axe de rotation du châssis mobile par rapport au châssis fixe.

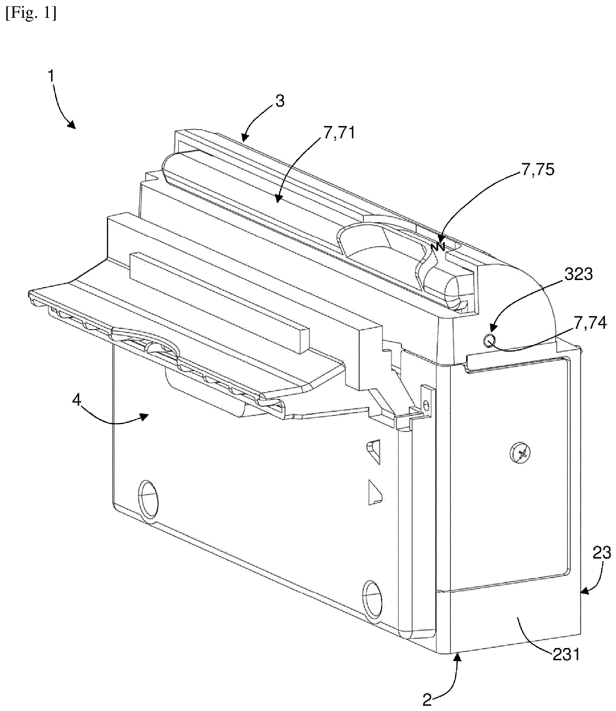

Les figures 1 à 10 illustrent un système 1 d'impression thermique selon l'invention.

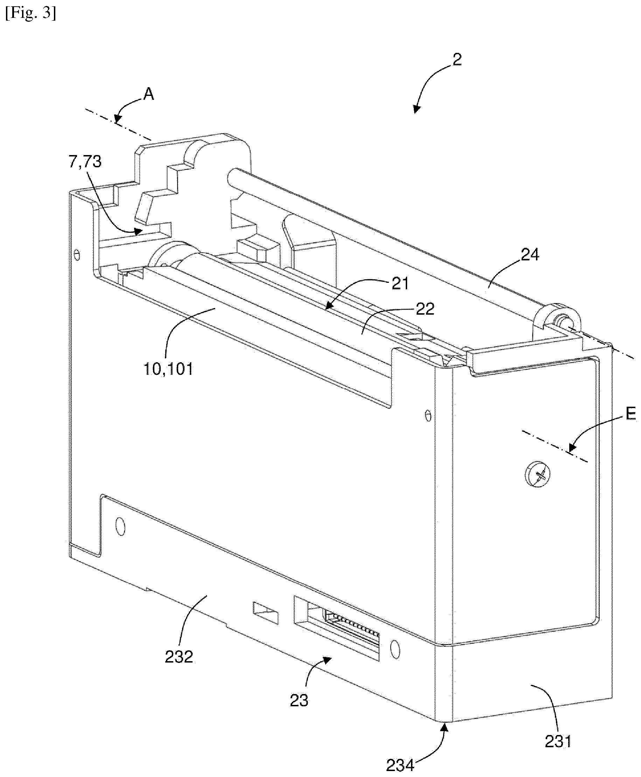

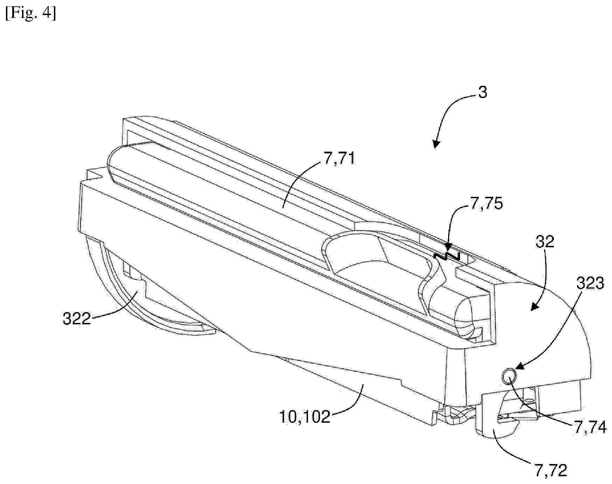

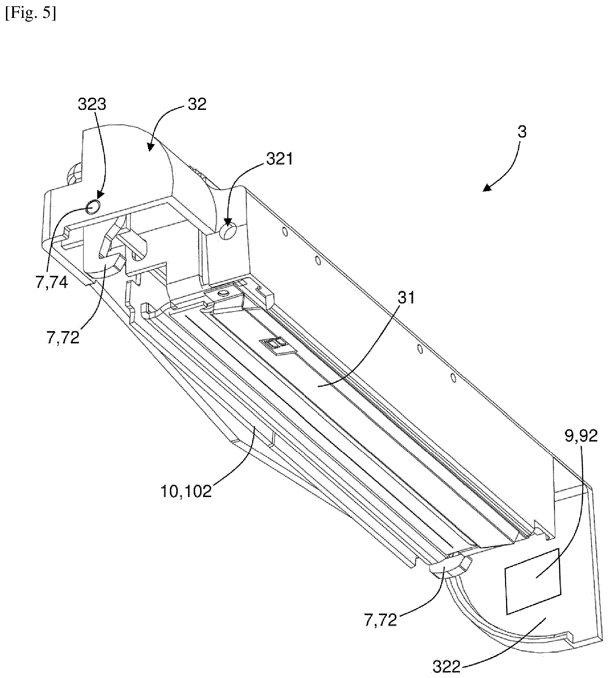

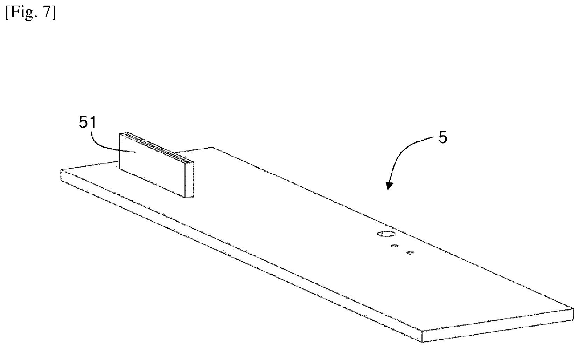

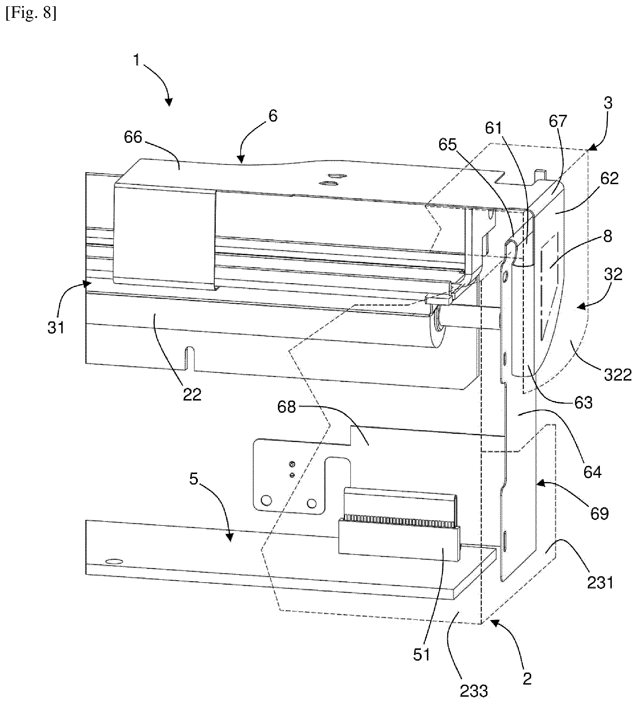

Le système 1 d'impression thermique comprend :
- un châssis fixe 2 ([Fig.3]) ;
- un châssis mobile 3 (figures 4 et 5) surmontant le châssis fixe 2 ;
- une bouche de sortie 4 ([Fig.1]) ;
- une carte électronique 5 ([Fig.7]) ;
- des moyens de connexion électrique (figures 8 à 10).

Les moyens de connexions électrique permettent de relier la carte électronique 5 aux différents composants solidaires du châssis fixe 2 et du châssis mobile 3.

Les moyens de connexion électrique prennent la forme d'une nappe souple 6 comme expliqué ci-après.

En référence à la [Fig.3], le châssis fixe 2 présente une surface de défilement 21 d'une bande de papier à imprimer.

Le châssis fixe 2 intègre un rouleau d'entraînement 22 de ladite bande en papier à imprimer. La surface de défilement 21 est alors formée par la génératrice du rouleau d'entraînement 22 avec laquelle la bande en papier à imprimer est en contact linéique.

Le rouleau d'entraînement 22 est monté mobile à rotation autour d'un axe d'entraînement E et est destiné à entraîner en défilement la bande de papier à imprimer.

Tel qu'illustré sur la [Fig.3], le châssis fixe 2 présente une armature 23 comprenant deux parois latérales 231 reliées l'une à l'autre par une paroi frontale 232 et une paroi arrière 233. En d'autres termes, les parois latérales 231 s'étendent entre la paroi frontale 232 et la paroi arrière 233.

La carte électronique 5, illustrée sur la [Fig.7], est logée dans le châssis fixe 2.

La carte électronique 5 est située au voisinage d'un fond 234 du châssis fixe 2.

Ce positionnement de la carte électronique 5 permet de faciliter le raccordement avec des moyens de contrôle d'un support dans lequel est intégré le système 1 d'impression thermique.

Le châssis mobile 3 est monté pivotant par rapport au châssis fixe 2 autour d'un axe de rotation A parallèle à l'axe d'entraînement E.

Pour cela, le châssis fixe 2 intègre également une tige 24 s'étendant entre les deux parois latérales 231 et formant des moyens de pivotement du châssis mobile 3 sur le châssis fixe 2.

La tige 24 est parallèle à l'axe d'entraînement E, comme illustré sur la [Fig.3].

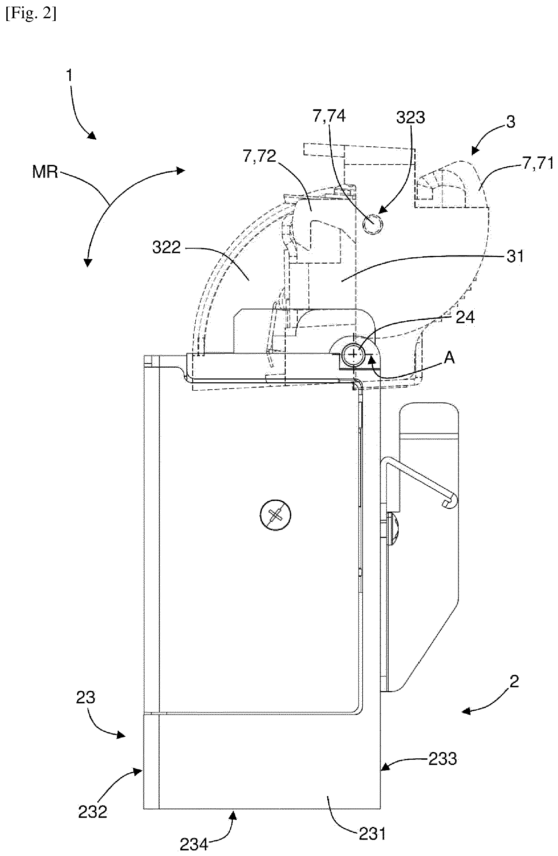

En référence à la [Fig.2], le châssis mobile 3 est monté pivotant par rapport au châssis fixe 2, selon un mouvement de rotation MR, entre une position refermée et une position ouverte.

En l'espèce, sur la [Fig.2], le châssis mobile 3 est illustré dans sa position ouverte.

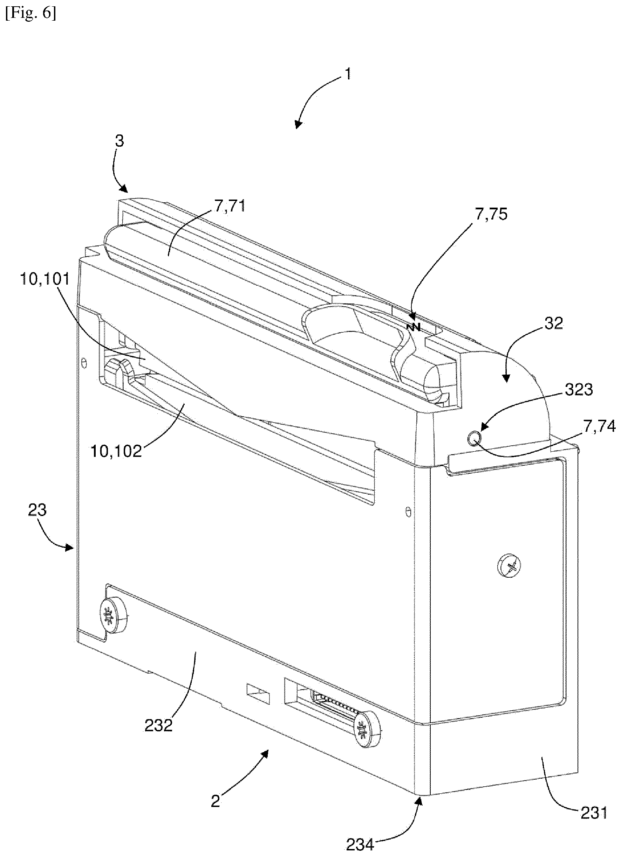

Dans sa position refermée, comme illustré sur les figures 1 et 6, le châssis mobile 3 est refermé sur la surface de défilement 21 du châssis fixe 2.

En revanche, dans sa position ouverte, le châssis mobile 3 est écarté de la surface de défilement 21 et laisse libre accès à cette dernière, comme illustré sur la [Fig.2]. Sur la [Fig.2], le châssis mobile 3 est illustré en traits pointillés.

La tige 24 forme l'axe de rotation A du châssis mobile 3 par rapport au châssis fixe 2.

En référence aux figures 4 et 5, le châssis mobile 3 est à présent décrit.

Le châssis mobile 3 porte une tête d'impression 31 destinée à être positionnée au regard de la surface de défilement 21 dans la position refermée du châssis mobile 3. La tête d'impression 31 porte une ligne de points chauffants en regard de la surface de défilement pour imprimer thermiquement la bande en papier qui défile entre la tête d'impression 31 et le rouleau d'entraînement 22.

Dans la position ouverte du châssis mobile 3, la tête d'impression 31 est écartée de la surface de défilement 21.

Le châssis mobile 3 comprend une coque 32 pourvue de deux orifices 321 opposés l'un par rapport à l'autre. Ces orifices 321 sont destinés à recevoir la tige 24 du châssis fixe 2 pour permettre le pivotement du châssis mobile 3 par rapport au châssis fixe 2.

La coque 32 présente une joue 322 qui s'étend transversalement à l'axe de rotation A lorsque le châssis mobile 3 est monté sur le châssis fixe 2.

Cette joue 322 permet, comme expliqué ci-après, de positionner et de protéger la nappe souple 6 lors de la manipulation du châssis mobile 3 pour le positionner dans sa position refermée ou dans sa position ouverte.

De préférence, la tête d'impression 31 est montée élastiquement dans la coque 32 du châssis mobile 3. Plus précisément, la tête d'impression 31 est montée élastiquement sur le châssis mobile 3 par l'intermédiaire d'un dispositif d'écartement qui tend à écarter la tête d'impression 31 en direction du châssis fixe 2. Ce dispositif d'écartement intègre des ressorts qui sont comprimés par la tête d'impression 31 lorsque le châssis mobile 3 est dans sa position refermée, et tendent alors à repousser la tête d'impression 31 contre le rouleau d'entraînement 22.

En référence à la [Fig.1], la bouche de sortie est destinée à être disposée en regard de la paroi frontale 232 de l'armature 23 du châssis fixe 2.

La bouche de sortie 4 permet à un utilisateur de pouvoir récupérer un papier imprimé généralement dispensé sous la forme d'un ticket ou d'un billet. La bouche de sortie 4 peut également présenter peut porter des diodes électroluminescentes permettant à un utilisateur d'être alerté de l'impression en cours et/ou de la fin de l'impression.

Pour permettre l'impression de données sur une bande de papier le système 1 d'impression thermique est relié à des moyens informatiques ou de communication par l'intermédiaire de la carte électronique 5.

En référence à la [Fig.7], la carte électronique 5 porte un composant de connexion 51 avec des moyens de connexion électrique permettant d'interconnecter la nappe souple 6 à la carte électronique 5 et de piloter l'ensemble du système 1 d'impression thermique.

Comme décrit précédemment, les moyens de connexion électrique prennent la forme d'une nappe souple 6, telle qu'illustrée sur les figures 8, 9 et 10.

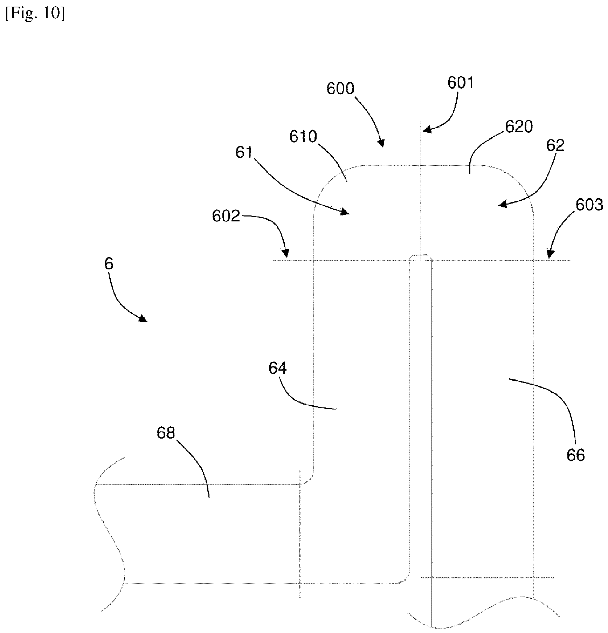

La nappe souple 6 de connexion électrique est d'abord formée à plat tel qu'illustré schématiquement sur la [Fig.10]. La nappe souple 6 est alors mise en forme pour être insérée à l'intérieur du châssis fixe 2 d'une part et du châssis mobile 3 d'autre part.

Tel qu'illustré sur la [Fig.8], la nappe souple 6 est formée, et le châssis fixe 2 est illustré de manière schématique.

La nappe souple 6 présente, en côté du châssis fixe 2, perpendiculairement à l'axe de rotation A, deux portions 61, 62 planes ou à tout le moins essentiellement planes s'étendant dans des plans parallèles entre eux.

Plus particulièrement, la nappe souple 6 présente une première portion 61 s'étendant vers la carte électronique 5 et une deuxième portion 62 s'étendant vers la tête d'impression 31.

La première portion 61 et la deuxième portion 62 sont reliées par un pli 63 à 180°. Le pli 63 à 180° est mobile dans un plan orthogonal à l'axe de rotation A entre la position ouverte et la position refermée du châssis mobile 3, ou inversement.

Le pli 63 à 180° permet, lors du pivotement du châssis mobile 3 par rapport au châssis fixe 2, de déformer la nappe souple 6 pour accompagner le mouvement du châssis mobile 3 par rapport au châssis fixe 2 et ainsi assurer une continuité électrique entre le châssis mobile 3 et le châssis fixe 2 indépendamment de leur position relative.

En outre, cela permet d'éviter une déconnexion électrique et une reconnexion électrique systématique du châssis mobile 3 mobile à la carte électronique lors de chaque ouverture ou fermeture du système 1 d'impression thermique, c'est-à-dire lors de chaque passage du châssis mobile 3 de sa position refermée à sa position ouverte, ou inversement.

La deuxième portion 62 de la nappe souple 6 est fixée au châssis mobile 3 par l'intermédiaire d'un ruban adhésif 8 de type double-face. Par type double-face, il est entendu que le ruban adhésif 8 présente deux face adhésives opposées l'une à l'autre.

Le ruban adhésif 8 est collé par une première de ces faces sur la deuxième portion 62 de la nappe souple 6 avant que sa deuxième face collante ne soit collée contre la joue 322 de la coque 32 du châssis mobile3.

La première portion 61 de la nappe souple 6 peut également être partiellement fixée sur le châssis fixe par l'intermédiaire d'un ruban adhésif de type double face.

Ainsi, la première portion 61 et la deuxième portion 62 demeurent partiellement fixes respectivement par rapport au châssis fixe 2 et au châssis mobile 3.

La nappe souple 6 comprend également une troisième portion 64 s'étendant dans le châssis fixe 2, dans un plan orthogonal à l'axe de rotation A.

Cette troisième portion 64 est reliée à la première portion 61 par un pli interne 65 à 180°.

La troisième portion 64 est solidaire du châssis fixe 2. Dès lors, la première portion 61, peut être libre en mouvement par rapport au châssis fixe 2, pour permettre un plus grand débattement angulaire entre le châssis mobile 3 et le châssis fixe2, tout en restant solidaire du châssis fixe 2 par l'intermédiaire de la troisième portion 64.

Autrement dit, la troisième portion 64 permet la solidarisation de la première portion 61 au châssis fixe 2.

La nappe souple 6 comprend également une quatrième portion 66 qui s'étend dans le châssis mobile 3, transversalement à la deuxième portion 62.

Cette quatrième portion 66 est reliée à la deuxième portion 62 par un pli de retour 67 à 90°.

La quatrième portion 66 permet la connexion électrique de la nappe souple 6 avec la tête d'impression 31. La quatrième portion 66 peut par exemple être en partie soudée à la tête d'impression 31.

En référence à la [Fig.10], la nappe souple 6 comprend, lorsque positionnée à plat entre la troisième portion 64 et la quatrième portion 66, une forme une U ayant une base 600, une première aile 610 destinée à former la première portion 61, et une deuxième aile 620 destinée à former la deuxième portion 62.

La base 600 présente :
- une première ligne de pli 601 de la nappe souple 6, à 180°, à la jonction entre la première aile 610 et la deuxième aile 620 ;
- une deuxième ligne de pli 602 de la nappe souple 6, à 180°, à la jonction entre la première aile 610 et la troisième portion 64, et
- une troisième ligne de pli 603 de la nappe souple 6, à 90°, à la jonction entre la deuxième aile 620 et la quatrième portion 66.

La première ligne de pli 601 est ainsi située entre la deuxième de pli 602 et la troisième ligne de pli 603.

La première ligne de pli 601 est destinée à matérialiser la zone de pliage de la nappe souple 6 pour former le pli 63 à 180°.

La deuxième ligne de pli 602 est destinée à matérialiser la zone de pliage de la nappe souple 6 pour former le pli interne 65 à 180°.

La troisième ligne de pli 603 est destinée à matérialiser la zone de pliage de la nappe souple 6 pour former le pli de retour 67 à 90°.

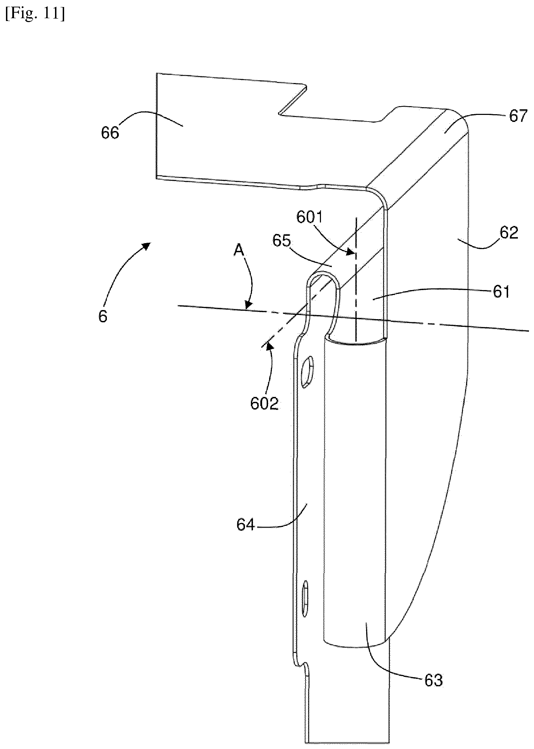

En référence à la [Fig.11], la première ligne de pli 601 est également destinée à former un axe de rayon de courbure du pli 63, et la deuxième ligne de pli 602 est destinée à former un axe de rayon de courbure du pli interne à 180° 65.

Tel que cela est visible sur la [Fig.11], dans la position refermée du châssis mobile, c'est-à-dire lorsque la nappe 6 est mise en forme, la première ligne 601, la deuxième ligne de pli 602 et l'axe de rotation A sont perpendiculaires deux à deux dans un espace tridimensionnel.

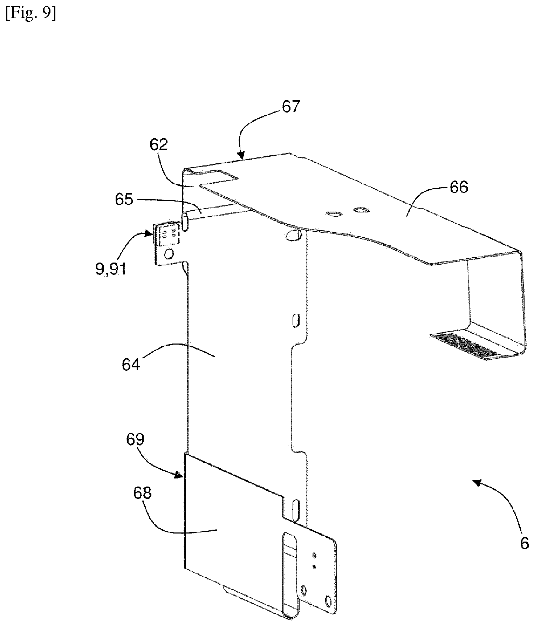

En référence aux figures 8 et 9, la nappe souple 6 comprend une cinquième portion 68 prolongeant la troisième portion 64 et formant un pli externe 69 sensiblement à angle droit avec la troisième portion 64.

La cinquième portion 68 permet la jonction de la nappe souple 6 avec la carte électronique 5.

Pour assurer le maintien en position refermée du châssis mobile 3 par rapport au châssis fixe 2, le système 1 d'impression thermique comprend un mécanisme de verrouillage 7 en position refermée du châssis mobile 3.

Ce mécanisme de verrouillage 7 comprend :
- un organe de manipulation 71 solidaire du châssis mobile 3 ;
- au moins un crochet 72 solidaire de l'organe de manipulation 71, et ;
- au moins un organe de retenue 73 du crochet 72 solidaire du châssis fixe 2.

Plus précisément, en référence à la [Fig.5], le châssis mobile 3 porte deux crochets 72 solidaires de l'organe de manipulation 71.

En référence à la [Fig.3], pour chaque crochet 72, le mécanisme de verrouillage 7 comprend un organe de retenue 73.

En l'espèce, chaque organe de retenue 73 est formé par un logement creusé dans les parois latérales 231 de l'armature 23.

L'organe de manipulation 71 est, quant à lui, monté à rotation sur le châssis mobile 3 au moyen d'un axe 74 venant se loger dans des lumières circulaires 323 de la coque 32 du châssis mobile 3.

En outre, ce mécanisme de verrouillage comprend également au moins un élément de rappel 75 intercalé entre l'organe de manipulation 71 et la coque du châssis mobile pour repousser l'organe de manipulation et donc les crochets dans une position de retenue ou de coopération avec le ou chaque organe de retenue.

L'élément de rappel 75 est schématiquement représenté sur la [Fig.4] comme étant un ressort de compression positionné à l'extérieur de la coque 32. Toutefois, l'élément de rappel 75 peut être positionné dans la coque 32 de sorte à ne pas être directement accessible.

Bien entendu, le mécanisme de verrouillage 7 pourrait être inversé. En d'autres termes, l'organe de manipulation 71 et les crochets 72 qui en sont solidaires seraient montés sur le châssis fixe 72, et le ou chaque organe de retenue 73 serait monté sur le châssis mobile 3.

Le système 1 d'impression thermique comprend également un dispositif de détection 9 de la position du châssis mobile 3 par rapport au châssis fixe 2 pour assurer une mise en sécurité du système 1 d'impression thermique lorsque le châssis mobile 3 est dans sa position ouverte.

Plus précisément, la mise en sécurité du système d'impression consiste à empêcher le fonctionnement de la tête d'impression 31 lorsque celle-ci n'est pas en regard de la surface de défilement 31, c'est-à-dire que le châssis mobile 3 n'est pas dans sa position refermée.

Le dispositif de détection 9 est relié à la carte électronique 5 de pilotage du système 1 d'impression thermique.

Le dispositif de détection 9 comprend :
- un capteur 91 à effet hall solidaire de l'un du châssis fixe 2 et du châssis mobile 3, et
- un aimant 92 permanent solidaire de l'autre du châssis mobile 3 et du châssis fixe 2.

Préférentiellement, le capteur 91 à effet hall est solidaire du châssis fixe 2 et l'aimant permanent 92 est solidaire du châssis mobile 3.

L'aimant permanent 92, représenté schématiquement sur la [Fig.5], est situé en regard du capteur 91 dans la position refermée.

Le système 1 d'impression thermique est notamment destiné à permettre l'impression de tickets ou de billets (par exemple les avions ou les trains) ou des tickets de reçus d'achats.

Ainsi, étant donné que le papier à imprimer entrant dans le système 1 d'impression thermique se présente sous la forme d'une bande de papier conditionné sous forme de rouleau, le système 1 d'impression thermique comprend un dispositif de découpe 10 de la bande de papier imprimée.

Cela permet alors de débiter les tickets ou les billets à récupérer par un utilisateur.

Le dispositif de découpe 10 comprend un premier organe de coupe 101 solidaire du châssis fixe 2 et un deuxième organe de coupe 102 solidaire du châssis mobile 3.

Le premier organe de coupe 101 et le deuxième organe de coupe 102 sont situés en regard l'un de l'autre dans la position fermée du châssis mobile 3.

Ainsi, lorsque le papier est imprimé, l'un au moins du premier organe de coupe 101 et du deuxième organe de coupe 102 se déplace en direction de l'autre pour découper la bande de papier imprimée et ainsi débiter un ticket ou un billet à récupérer par l'utilisateur dans la bouche de sortie 4.

Le premier organe de coupe 101 et le deuxième organe de coupe 102 sont montés mobiles et actionnés par un moteur dédié.

Le premier organe de coupe 101 et le deuxième organe de coupe 102 se présentent chacun sous la forme d'une lame.

Lors du pivotement du châssis mobile 3 par rapport au châssis fixe 2, le pli 63 à 180° se déplace sur la première portion 61 ou sur la deuxième portion 62 de la nappe souple 6.

Plus particulièrement, lorsque le châssis mobile 3 passe de sa position refermée à sa position ouverte, le pli 63 à 180° se déplace en direction de la première portion 61, ce qui a pour effet de réduire la taille de la première portion 61, et d'augmenter la taille de la deuxième portion 62.

A l'inverse, lorsque le châssis mobile 3 passe de sa position ouverte à sa position refermée, le pli 63 à 180° se déplace en direction de la deuxième portion 62, ce qui a pour effet de réduire la taille de la deuxième portion 62, et d'augmenter la taille de la première portion 61.

Le système 1 d'impression thermique selon l'invention permet ainsi de multiplier ou d'additionner les avantages des solutions existantes tout en réduisant leurs inconvénients.

Plus précisément, grâce au pivotement du châssis mobile 3 par rapport au châssis fixe 2 selon un parallèle à l'axe d'entraînement E, le volume libre nécessaire à la mobilité du châssis mobile 3 est réduit comparativement aux systèmes dont la rotation du châssis mobile 3 se fait orthogonalement à l'axe d'entraînement E.

De plus l'utilisation d'une nappe souple 6 permet de conserver la connexion électrique entre le châssis mobile 3 et la carte électronique 5 malgré le pivotement du châssis mobile 3, sans risque de détérioration de la nappe souple 6 grâce au pli 63 à 180°.

En outre, l'utilisation d'un ruban adhésif 8 de type double-face pour permettre la fixation de la deuxième portion 62 de la nappe souple 6 sur le châssis mobile 3, favorise un repliement ordonné de la nappe souple 6 ce qui évite de la dégrader par exemple par pincement entre le châssis mobile 3 et le châssis fixe 2.

## Revendications

1. Système (1) d'impression thermique, du type comprenant :
- un châssis fixe (2) intégrant un rouleau d'entraînement (22) mobile à rotation autour d'un axe d'entraînement (E) et destiné à entraîner un défilement d'une bande de papier ;
- un châssis mobile (3) surmontant le châssis fixe (2) et portant une tête d'impression (31) en regard du rouleau d'entraînement (22), le châssis mobile (3) étant monté pivotant par rapport au châssis fixe (2) autour d'un axe de rotation (A) parallèle à l'axe d'entraînement (E) entre une position refermée sur la surface de défilement (21) et une position ouverte dans laquelle il est écarté de la surface de défilement (21),
- des moyens de connexion électrique de la tête d'impression (31) à des moyens de pilotage,
**caractérisé en ce que** les moyens de connexion électrique prennent la forme d'une nappe souple (6) de connexion électrique,
et **en ce que** la nappe souple (6) présente, en côté du châssis fixe (2), dans la position refermée du châssis mobile (3), deux portions essentiellement planes s'étendant dans des plans parallèles entre eux, dont une première portion (61) de connexion à des moyens de pilotage, solidaire du châssis fixe (2), et une deuxième portion (62) de connexion à la tête d'impression (31), solidaire du châssis mobile (3), la première portion (61) et la deuxième portion (62) étant reliées par un pli (63) à 180° mobile dans un plan orthogonal à l'axe de rotation (A) entre la position ouverte et la position refermée du châssis mobile (3) ou inversement.

2. Système (1) d'impression thermique selon la revendication précédente, **caractérisé en ce que** la nappe souple (6) comprend, lorsque positionnée à plat entre une troisième portion (64) et une quatrième portion (66), une forme en U ayant une base (600), une première aile (610) destinée à former la première portion (61), et une deuxième aile (620) destinée à former la deuxième portion (62), la base (600) présentant :
- une première ligne de pli (601) de la nappe souple (6) à 180° à la jonction entre la première aile (610) et la deuxième aile (620) ;
- une deuxième ligne de pli (602) de la nappe souple (6) à 180° à la jonction entre la première aile (610) et la troisième portion (64), et
- une troisième ligne de pli (603) de la nappe souple (6) à 90° située entre la deuxième aile (620) et la quatrième portion (66).

3. Système (1) d'impression thermique selon l'une quelconque des revendications précédentes, **caractérisé en ce qu'**il comprend également un dispositif de détection (9) de la position du châssis mobile (3) par rapport au châssis fixe (2), ce dispositif de détection (9) étant relié à la carte électronique (5) de pilotage du système (1) d'impression thermique pour assurer une mise en sécurité du système (1) d'impression thermique lorsque le châssis mobile (3) est dans sa position ouverte.

4. Système (1) d'impression thermique selon la revendication précédente, **caractérisé en ce que** le dispositif de détection (9) comprend :
- un capteur (91) à effet hall solidaire de l'un du châssis fixe (2) et du châssis mobile (3), et
- un aimant permanent (92) solidaire de l'autre du châssis mobile (3) et du châssis fixe (2),
le capteur (91) et l'aimant permanent (92) étant en regard l'un de l'autre dans la position refermée du châssis mobile (3).

5. Système (1) d'impression thermique selon l'une quelconque des revendications précédentes, **caractérisé en ce qu'**il comprend un mécanisme de verrouillage (7) en position refermée du châssis mobile (3).

6. Système (1) d'impression thermique selon la revendication précédente, **caractérisé en ce que** le mécanisme de verrouillage (7) comprend :
- un organe de manipulation (71) solidaire du châssis mobile (3) ;
- au moins un crochet (72) solidaire de l'organe de manipulation (71), et
- au moins un organe de retenue (73) du crochet (72) solidaire du châssis fixe (2).

7. Système (1) d'impression thermique selon l'une quelconque des revendications précédentes, **caractérisé en ce que** la deuxième portion (62) de la nappe souple (6) est fixée au châssis mobile (3) par l'intermédiaire d'un ruban adhésif (8) de type double face.

8. Système (1) d'impression thermique selon l'une quelconque des revendications précédentes, **caractérisé en ce qu'**il comprend un dispositif de découpe (10) d'une bande de papier imprimée, le dispositif de découpe (10) comprenant un premier organe de coupe (101) solidaire du châssis fixe (2), et un deuxième organe de coupe (102) solidaire du châssis mobile (3), en regard du premier organe de coupe (101).

9. Système (1) d'impression thermique selon la revendication 2, **caractérisé en ce que** la nappe souple (6) comprend une cinquième portion (68) prolongeant la troisième portion (64) et formant un pli externe (69) à 90° avec la troisième portion (64).

10. Système (1) d'impression thermique selon la revendication précédente, **caractérisé en ce qu'**il comprend une carte électronique (5) de pilotage du système (1) d'impression thermique montée fixement par rapport au châssis fixe (2).

11. Système (1) d'impression selon la revendication 2, **caractérisé en ce que** :
- la deuxième ligne de pli (602) est destinée à former un axe de rayon de courbure d'un pli interne (65) entre la première portion (61) et la troisième portion (64),
- la première ligne de pli (601) est destinée à former un axe de rayon de courbure du pli à 180° (63),
et **en ce que**, dans la position refermée du châssis mobile (3), la première ligne (601), la deuxième ligne de pli (602) et l'axe de rotation (A) sont perpendiculaires deux à deux dans un espace tridimensionnel.

## Patentansprüche

1. Thermodrucksystem (1) des Typs, umfassend:
- einen festen Rahmen (2), in den eine Antriebsrolle (22) integriert ist, die sich um eine Antriebsachse (E) dreht und zum Abrollen einer Papierbahn dient;
- einen beweglichen Rahmen (3), der den festen Rahmen (2) übersteht und einen Druckkopf (31) gegenüber der Antriebsrolle (22) trägt, wobei der bewegliche Rahmen (3) schwenkbar gegenüber dem festen Rahmen (2) um eine Drehachse (A) parallel zu der Antriebsachse (E) zwischen einer geschlossenen Position auf der Lauffläche (21) und einer offenen Position montiert ist, in der er von der Lauffläche (21) wegbewegt ist,
- elektrische Verbindungsmittel des Druckkopfs (31) an Steuermittel,
**dadurch gekennzeichnet, dass** die elektrischen Verbindungsmittel die Form einer weichen Matte (6) zur elektrischen Verbindung annehmen,
und dass die weiche Matte (6) an der Seite des festen Rahmens (2) in der geschlossenen Position des beweglichen Rahmens (3) zwei im Wesentlichen flache Abschnitte aufweist, die sich in parallel zueinander verlaufenden Ebenen erstrecken, davon ein erster Abschnitt (61) zur Verbindung mit Steuermitteln, der fest mit dem festen Rahmen (2) verbunden ist, und ein zweiter Abschnitt (62) zur Verbindung mit dem Druckkopf (31), der fest mit dem beweglichen Rahmen (3) verbunden ist, wobei der erste Abschnitt (61) und der zweite Abschnitt (62) durch eine um 180° bewegliche Falte (63) verbunden sind, die in einer Ebene orthogonal zur Drehachse (A) zwischen der offenen und der geschlossenen Position des beweglichen Rahmens (3) oder umgekehrt beweglich ist.

2. Thermodrucksystem (1) nach dem vorhergehenden Anspruch, **dadurch gekennzeichnet, dass** die weiche Matte (6), wenn sie flach zwischen einem dritten Abschnitt (64) und einem vierten Abschnitt (66) positioniert ist, eine U-Form mit einer Basis (600), einem ersten Flügel (610) zur Bildung des ersten Abschnitts (61) und einem zweiten Flügel (620), zur Bildung des zweiten Abschnitts (62) umfasst, wobei die Basis (600) Folgendes aufweist:
- eine erste Faltlinie (601) der weichen Matte (6) in einem Winkel von 180° an der Verbindungsstelle zwischen dem ersten Flügel (610) und dem zweiten Flügel (620);
- eine zweite Faltlinie (602) der weichen Matte (6) in einem Winkel von 180° an der Verbindungsstelle zwischen dem ersten Flügel (610) und dem dritten Abschnitt (64), und
- eine dritte Faltlinie (603) der weichen Matte (6) in einem Winkel von 90° zwischen dem zweiten Flügel (620) und dem vierten Abschnitt (66).

3. Thermodrucksystem (1) nach einem der vorhergehenden Ansprüche, **dadurch gekennzeichnet, dass** es auch eine Erkennungsvorrichtung (9) für die Position des beweglichen Rahmens (3) in Bezug auf den festen Rahmen (2) umfasst, wobei die Erkennungsvorrichtung (9) mit der elektronischen Karte (5) zur Steuerung des Thermodrucksystems (1) verbunden ist, um eine Sicherung des Thermodrucksystems (1) zu gewährleisten, wenn sich der bewegliche Rahmen (3) in seiner geöffneten Position befindet.

4. Thermodrucksystem (1) nach dem vorhergehenden Anspruch, **dadurch gekennzeichnet, dass** die Erkennungsvorrichtung (9) Folgendes umfasst:
- einen Halleffektsensor (91), der fest mit dem festen Rahmen (2) und dem beweglichen Rahmen (3) verbunden ist, und
- einen Permanentmagneten (92), der mit dem anderen fest mit dem beweglichen Rahmen (3) und dem festen Rahmen (2) verbunden ist,
wobei der Sensor (91) und der Permanentmagnet (92) in der geschlossenen Position des beweglichen Rahmens (3) einander gegenüberstehen.

5. Thermodrucksystem (1) nach einem der vorhergehenden Ansprüche, **dadurch gekennzeichnet, dass** es einen Verriegelungsmechanismus (7) in geschlossener Position des beweglichen Rahmens (3) umfasst.

6. Thermodrucksystem (1) nach dem vorhergehenden Anspruch, **dadurch gekennzeichnet, dass** der Verriegelungsmechanismus (7) Folgendes umfasst:
- ein Handhabungselement (71), das fest mit dem beweglichen Rahmen (3) verbunden ist;
- mindestens einen Haken (72), der fest mit dem Handhabungselement (71) verbunden ist, und
- mindestens ein Halteelement (73) des Hakens (72), der mit dem festen Rahmen (2) verbunden ist.

7. Thermodrucksystem (1) nach einem der vorhergehenden Ansprüche, **dadurch gekennzeichnet, dass** der zweite Abschnitt (62) der weichen Matte (6) über ein doppelseitiges Klebeband (8) am beweglichen Rahmen (3) befestigt ist.

8. Thermodrucksystem (1) nach einem der vorhergehenden Ansprüche, **dadurch gekennzeichnet, dass** es eine Schneidvorrichtung (10) für einen bedruckten Papierstreifen umfasst, wobei die Schneidvorrichtung (10) ein erstes Schneidorgan (101) umfasst, das fest mit dem festen Rahmen (2) verbunden ist, und ein zweites Schneidorgan (102), das fest mit dem beweglichen Rahmen (3) verbunden ist, gegenüber dem ersten Schneidorgan (101).

9. Thermodrucksystem (1) nach Anspruch 2, **dadurch gekennzeichnet, dass** die weiche Matte (6) einen fünften Abschnitt (68) umfasst, der den dritten Abschnitt (64) verlängert und eine äußere Falte (69) in einem Winkel von 90° mit dem dritten Abschnitt (64) bildet.

10. Thermodrucksystem (1) nach dem vorhergehenden Anspruch, **dadurch gekennzeichnet, dass** es eine elektronische Karte (5) zur Steuerung des Thermodrucksystems (1) umfasst, die fest in Bezug auf den festen Rahmen (2) montiert ist.

11. Drucksystem (1) nach dem Anspruch 2, **dadurch gekennzeichnet, dass**:
- die zweite Faltlinie (602) dazu bestimmt ist, eine Krümmungsradiusachse einer inneren Falte (65) zwischen dem ersten Abschnitt (61) und dem dritten Abschnitt (64) zu bilden,
- die erste Faltlinie (601) dazu bestimmt ist, eine Krümmungsradiusachse der um 180° beweglichen Falte (63) zu bilden,
und dass in der geschlossenen Position des beweglichen Rahmens (3) die erste Linie (601), die zweite Faltlinie (602) und die Drehachse (A) in einem dreidimensionalen Raum paarweise senkrecht zueinander stehen.

## Claims

1. A thermal printing system (1), of the type comprising:
- a fixed frame (2) integrating a drive roller (22) rotatably movable about a drive axis (E) and for causing a paper tape to run;
- a movable frame (3) having the fixed frame (2) thereabove and carrying a print head (31) facing the drive roller (22), the movable frame (3) being pivotably mounted relative to the fixed frame (2) about an axis of rotation (A) parallel to the drive axis (E) between a closed position on the running surface (21) and an open position in which it is spaced apart from the running surface (21),
- means for electrically connecting the print head (31) to control means,
**characterised in that** the electrical connection means take the form of a flexible electrical connection web (6),
and **in that** the flexible web (6) has, on the side of the fixed frame (2), in the closed position of the movable frame (3), two essentially planar portions extending in planes parallel to each other, including a first portion (61) for connecting to control means, integral with the fixed frame (2), and a second portion (62) for connecting to the print head (31), integral with the movable frame (3), the first portion (61) and the second portion (62) being connected by a 180° fold (63) movable in a plane orthogonal to the axis of rotation (A) between the open position and the closed position of the movable frame (3) or conversely.

2. The thermal printing system (1) according to the preceding claim, **characterised in that** the flexible web (6) comprises, when positioned flat between a third portion (64) and a fourth portion (66), a U-shape having a base (600), a first wing (610) for forming the first portion (61), and a second wing (620) for forming the second portion (62), the base (600) having:
- a first fold line (601) of the flexible web (6) at 180° at the junction between the first wing (610) and the second wing (620);
- a second fold line (602) of the flexible web (6) at 180° at the junction between the first wing (610) and the third portion (64), and
- a third fold line (603) of the flexible web (6) at 90° located between the second wing (620) and the fourth portion (66).

3. The thermal printing system (1) according to any one of the preceding claims, **characterised in that** it also comprises a detection device (9) for detecting position of the movable frame (3) with respect to the fixed frame (2), this detection device (9) being connected to the electronic board (5) for controlling the thermal printing system (1) to ensure securing of the thermal printing system (1) when the movable frame (3) is in its open position.

4. The thermal printing system (1) according to the preceding claim, **characterised in that** the detection device (9) comprises:
- a hall effect sensor (91) integral with one of the fixed frame (2) and the movable frame (3), and
- a permanent magnet (92) integral with the other of the movable frame (3) and the fixed frame (2),
the sensor (91) and the permanent magnet (92) facing each other in the closed position of the movable frame (3).

5. The thermal printing system (1) according to any one of the preceding claims, **characterised in that** it comprises a locking mechanism (7) in the closed position of the movable frame (3).

6. The thermal printing system (1) according to the preceding claim, **characterised in that** the locking mechanism (7) comprises:
- a handling member (71) integral with the movable frame (3);
- at least one hook (72) integral with the handling member (71), and
- at least one retaining member (73) for the hook (72) integral with the fixed frame (2).

7. The thermal printing system (1) according to any one of the preceding claims, **characterised in that** the second portion (62) of the flexible web (6) is fastened to the movable frame (3) by means of a double-sided adhesive tape (8).

8. The thermal printing system (1) according to any one of the preceding claims, **characterised in that** it comprises a cutting device (10) for cutting a printed paper tape, the cutting device (10) comprising a first cutting member (101) integral with the fixed frame (2), and a second cutting member (102) integral with the movable frame (3), facing the first cutting member (101).

9. The thermal printing system (1) according to claim 2, **characterised in that** the flexible web (6) comprises a fifth portion (68) extending from the third portion (64) and forming an outer fold (69) at 90° with the third portion (64).

10. The thermal printing system (1) according to the preceding claim, **characterised in that** it comprises an electronic board (5) for controlling the thermal printing system (1) fixedly mounted relative to the fixed frame (2).

11. The thermal printing system (1) according to claim 2, **characterised in that**:
- the second fold line (602) is to form an axis of radius of curvature of an inner fold (65) between the first portion (61) and the third portion (64),
- the first fold line (601) is to form an axis of radius of curvature of the 180° fold (63),
and **in that**, in the closed position of the movable frame (3), the first line (601), the second fold line (602) and the axis of rotation (A) are perpendicular two to two in a three-dimensional space.
